**Europäisches Patentamt**

**European Patent Office**

**Office européen des brevets**

(19)

(11) Veröffentlichungsnummer: **0 012 840**
**B1**

(12) **EUROPÄISCHE PATENTSCHRIFT**

(45) Veröffentlichungstag der Patentschrift:
23.02.83

(51) Int. Cl.³: **G 11 C 19/28**

(21) Anmeldenummer: **79104586.7**

(22) Anmeldetag: **19.11.79**

(54) **Zellenadressierbarer Speicher in Serien-Parallel-Serien-Konfiguration.**

(30) Priorität: **29.12.78 US 974634**

(43) Veröffentlichungstag der Anmeldung:
**09.07.80 Patentblatt 80/14**

(45) Bekanntmachung des Hinweises auf die Patenterteilung:
**23.02.83 Patentblatt 83/8**

(84) Benannte Vertragsstaaten:
**DE FR GB NL SE**

(56) Entgegenhaltungen:
FR-A-2 316 800
US-A-3 720 922
US-A-3 760 202
US-A-3 967 254
US-A-4 011 548
US-A-4 165 541

IEEE JOURNAL OF SOLID-STATE CIRCUITS, Band SC-10, Nr. 5, Oktober 1975, Seiten 268–273 New York, U.S.A. GUNSAGAR et al.: «A CCD Line Addressable Random Access Memory (LARAM)

IEEE JOURNAL OF SOLID-STATE CIRCUITS, Band SC-13, Nr. 5, Oktober 1978, Seiten 681–687 New York, U.S.A. VARSHNEY et al.: «A Block Organized 64-kbit CCD Memory»

(73) Patentinhaber: **International Business Machines Corporation, Armonk, N.Y. 10504 (US)**

(72) Erfinder: **Lee, Hua-Tung, 2 Skyview Drive, Poughkeepsie N. Y. 12603 (US)**

(74) Vertreter: **Rudolph, Wolfgang, Schönaicher Strasse 220, D-7030 Böblingen (DE)**

(56) Entgegenhaltungen:
IEEE JOURNAL OF SOLID-STATE CIRCUITS, Band SC-9, Nr. 6, Dezember 1974, Seiten 436–443 New York, U.S.A. KRAMBECK et al.: «A 4160 Bit C4D Serial Memory»

IEEE JOURNAL OF SOLID-STATE CIRCUITS, Band SC-11, Nr. 1, Februar 1976, Seiten 4–10 New York, U.S.A. TERMAN et al.: «Overview of CCD Memory»

IEEE JOURNAL OF SOLID-STATE CIRCUITS, Band SC-11, Nr. 1, Februar 1976, Seiten 10–18 New York, U.S.A. SUNLIN CHOU: «Design of a 16384 Bit Serial Charge-Coupled Memory Device»

IEEE JOURNAL OF SOLID-STATE CIRCUITS, Band
SC-11, Nr. 1, Februar 1976, Seiten 40–48 New York,
U.S.A. MOHSEN et al.: «A 16-kbit Block Addressed
Charge-Couplet Memory Device»

INTEL MEMORY DESIGN HANDBOOK, Intel, 1975,
Seiten 9–1 – 9–30 Santa Clara, U.S.A. PAPENBERG:
«Design and Applications of Intel's 2416 16K Charge
Couplet Device»

## Zeilenadressierbarer Speicher in Serien-Parallel-Serien-Konfigurationen

Die vorliegende Erfindung betrifft einen zeilenadressierbaren Speicher mit serieller Biteingabe und -ausgabe nach dem Oberbegriff des Anspruchs 1.

In der Technik ist die Verwendung von Ladungskopplungselementen in Datenspeichern, primär in der Form von Schieberegistern, in die Daten als serieller Bitstrom an einem Ende des Schieberegisters ein- und anderen Ende wieder ausgelesen werden, allgemein bekannt.

Ein wesentlicher Fortschritt war das seriell-parallel-seriell geschaltete Schieberegister gemäss US-A-3 967 254 aus Ladungskopplungselementen. Ein solcher Speicher besteht aus drei Hauptteilen. Der erste Teil dient der bitweisen Dateneingabe in ein serielles Eingaberegister. Im zweiten Teil werden Daten parallel vom seriellen Eingaberegister in einen parallelen Teil übertragen. Das wird allgemein als eine Datenzeile im parallelen Teil bezeichnet. Der parallele Teil enthält typischerweise viele Zeilen, weil hier der grösste Teil der Daten gespeichert wird. Während einzelne Datenbits am Anfang bitweise in das serielle Eingaberegister eingegeben wurden, erfolgt die Weiterleitung durch das parallele Register jetzt zeilenweise.

Tatsächlich laufen die einzelnen Bits in ihren betreffenden Kanälen, die üblicherweise Spalten genannt werden, weiter. Diese Spalten verlaufen othogonal zu den Zeilen. Im dritten Teil werden Daten aus der letzten Zeile des parallelen Teiles in das serielle Ausgaberegister übertragen, von wo sie seriell bitweise ausgelesen werden. Die Ausgabe kann dann an ein Benutzergerät übertragen und/oder an den Eingang des seriellen Eingaberegisters zur weiteren Datenspeicherung zurückgeleitet werden.

Die oben allgemein beschriebene Anordnung, in breitem Rahmen serielle-parallele-serielle Schaltung genannt, hat eine Anzahl von Vorteilen, aber natürlich auch inhärente Nachteile. Zu den Vorteilen gehören die Speicherdichte, die niedrigen Speicherkosten pro Bit und der geringere Stromverbrauch. Ein Hauptnachteil besteht jedoch in der grossen Latenzzeit, weil die Bits immer nur in genau derselben Reihenfolge ausgelesen werden können, in der sie ursprünglich eingeschrieben wurden. Wenn das Benutzergerät also Daten braucht, die gerade in das serielle Eingaberegister eingeschrieben wurden, muss der ganze Speicher erst umlaufen, bevor diese Information am seriellen Ausgaberegister zur Verfügung steht.

Um die Daten besser wahlfrei adressieren zu können, wurden herkömmliche Speicher mit Zeilenadressierung entwickelt. Bei einem solchen Speicher gemäss US-PS 40 24 512 werden Daten in eine Zeile von Schieberegistern eingegeben und von dort ausgelesen. Zur Beschreibung sei angenommen, dass diese Zeilen in derselben Richtung laufen wie die vorher in der SPS-Struktur definierten Spalten. Eine mögliche praktische Ausführung besteht darin, dass jede zweite Spalte in der entgegengesetzten Richtung weiterleitet, was zu kontinuierlichen Schleifen führt, die von jedem Spaltenpaar gebildet werden. Der zeilenadressierbare Speicher enthält viele derartige Schleifen, die parallel arbeiten. Wie der Name schon sagt, hat der zeilenadressierbare Speicher eine ausreichende Beweglichkeit zum Auslesen aus irgendeiner Spalte oder Schleife. Das Benutzergerät hat also direkten Zugriff zu den gewünschten Daten (Latenzzeit Null). Diese stark verbesserte Arbeitsgeschwindigkeit gegenüber einer seriellen-parallelen-seriellen Struktur geht jedoch auf Kosten einer geringeren Bitdichte und eines grösseren Stromverbrauches, die beide zu höheren Speicherkosten pro Bit führen.

Weder die serielle-parallele-serielle Konstruktion noch die zeilenadressierbare Konstruktion eines Speichers liefern also das angestrebte Optimum an Betriebsbedingungen.

Aus der US-A-4 011 548 ist ausserdem ein CCD-Speicher mit einer Gleichspannungs-Steuerleitung bekannt geworden, der zeilenadressierbar ist und zwei Phasensteuerleitungen aufweist. Bei diesem Speicher handelt es sich jedoch nicht um einen zeilenadressierbaren Speicher in Serien-Parallel-Serien-Konfiguration.

Die Aufgabe der Erfindung besteht darin, einen verbesserten elektronischen Datenspeicher zu schaffen, der sowohl die Eigenschaften eines seriellen-parallelen-seriellen Datenspeichers als auch diejenigen eine zeilenadressierbaren Datenspeichers hat, der aus Ladungskopplungselementen zusammengesetzt ist und aus dem Daten seriell in mehr als einer Betriebsart ausgelesen werden können.

Die erfindungsgemässe Lösung dieser Aufgabe ist im Anspruch 1 angegeben.

Vorteilhafte Ausgestaltungen der Erfindung sind in den Kennzeichen der Patentansprüche 2 bis 6 gekennzeichnet.

In einem derartigen Speicher werden die Vorteile der SPS-Konfiguration erhalten und gleichzeitig wird die Betriebsgeschwindigkeit eines zeilenadressierbaren Speichers ermöglicht, ohne dass die Bitdichte herabgesetzt wird und ein höherer Stromverbrauch erforderlich ist. Durch die zweiphasige Ausführung eines derartigen Speichers und durch die Zeilenadressierung mittels einer Gleichspannungs-Steuerleitung für jeden Kanal ist eine sehr grosse Flexibilität und Geschwindigkeit erreichbar. Dadurch, dass die Gleichstrom-Steuerelektroden (Sperrelektroden) auf der dritten Ebene realisiert werden, tritt keine wesentliche Belastung für eine vorhandene SPS-Speicherschaltung auf.

Ein Ausführungsbeispiel der Erfindung ist in den beigefügten Zeichnungen dargestellt und wird anschliessend näher beschrieben.

Es zeigen:

Fig. 1 ein System, das in Ruhezustand durch leere Bits im seriellen Eingaberegister definiert ist,

Fign. 2A bis 2F den Datenfluss, wenn der serielle-parallele-serielle Speicher in Zeilenadressierung betrieben wird,

Fig. 3 drei Zellen, die in Ladungskopplungstechnik (CCD) ausgeführt im Weiterleitungsbetrieb betrieben werden.

Fign. 3A bis 3D Energieniveaus zur Darstellung des Ladungsflusses in der in Fig. 3 gezeigten Struktur,

Fig. 3E mehrere Wellenlinien zur Darstellung der Steuerspannung an jeder Elektrode in Fig. 3,

Fig. 4 schematisch drei in Ladungskopplungstechnik ausgeführte Zellen, die im Haltebetrieb betrieben werden,

Fign. 4A bis 4D Energieniveaus zur Darstellung des Ladungsflusses in der in Fig. 4 gezeigten Struktur,

Fig. 4E mehrere Wellenlinien zur Darstellung der Steuerspannung an jeder Elektrode der in Fig. 4 gezeigten Struktur,

Fig. 5 die horizontale Lage des seriellen-parallelen-seriellen zeilenadressierbaren Speichers der vorliegenden Erfindung,

Fig. 6 in einer Vergrösserung der Fig. 5 die Struktur im Bereich der Schnittlinie 6,

Fig. 6A einen vertikalen Schnitt entlang der Schnittlinie 6A in Fig. 6,

Fig. 7 eine Vergrösserung der Fig. 5 in einem Bereich entlang der Schnittlinien 7A und 7B,

Fig. 7A einen vertikalen Schnitt der vergrösserten horizontalen Auslegung der Fig. 7 entlang der Schnittlinien 7A,

Fig. 7B einen vertikalen Schnitt der horizontalen Auslegung entlang der Schnittlinie 7B in Fig. 7,

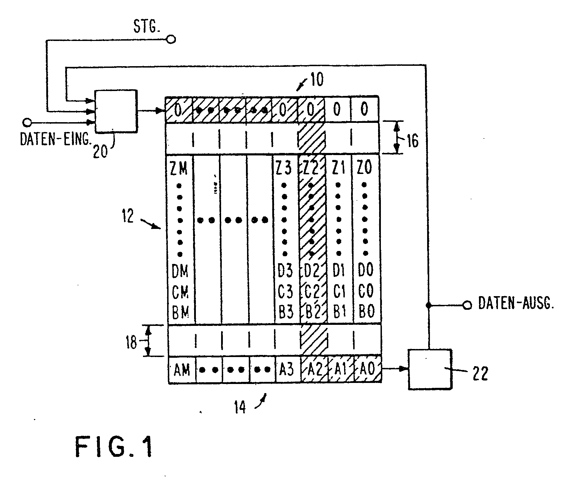

Fig. 1 zeigt schematisch eine serielle-parallele-serielle Konfiguration (SPS) mit einem seriellen Eingangsregister 10, einem parallelen Mittelteil 12 und einem seriellen Ausgangsregister 14. Derartige Schaltungsanordnungen enthalten häufig auch noch einen Serien/Parallelwandler 16 und einen Parallel/Serienwandler 18. Leitungs-, Takt- und Ladeschaltungen für solche SPS-Konfigurationen sind allgemein bekannt und im Leit- und Taktschaltblock 20 schematisch dargestellt. Ebenfalls an sich bekannt sind Ladungsabfühl- und Verstärkerschaltungen mit Rücklaufverstärkern, wie sie allgemein durch den Abfrageverstärker 22 dargestellt sind. Ein Signal am Steuereingangsanschluss bestimmt, wann neue Daten am Dateneingangsanschluss oder vom Abfrageverstärker 22 zurückgeführte Daten in die erste Bitposition des seriellen Eingaberegisters 10 einzugeben sind. Auch im Umlaufbetrieb können Daten am Datenausgangsanschluss gleichzeitig genutzt werden.

Eine erfindungsgemässe Schaltung kann voll als standardmässige SPS-Schaltungskonfiguration betrieben werden. Auf bekannte Weise werden Datenbits seriell von links nach rechts in das serielle Eingangsregister 10 eingegeben. Wenn die gewünschte Anzahl von Bits in das Eingangsregister 10 eingegeben ist, werden sie parallel über den Serien/Parallelwandler 16 in eine erste Zeile des parallelen Mittelteiles 12 eingegeben. Dann werden neue Daten in das serielle Eingaberegister 10 eingegeben und wieder durch den Serien/Parallelwandler 16 in die erste Zeile des parallelen Mittelteiles 12 eingegeben, während die vorher dort stehenden Daten in die zweite Zeile gesetzt werden. Auf diese Weise wird der parallele Mittelteil 12 zeilenweise mit Daten gefüllt. Wenn die zuerst eingegebenen Daten die letzte Zeile des parallelen Mittelteiles 12 erreichen, werden sie parallel durch den Parallel/Serienwandler 18 in das serielle Ausgangsregister 14 gegeben. Hier werden Daten bitweise in den Abfrageverstärker 22 und von dort weiter an den Datenausgangsanschluss und an den angegebenen Eingang des Leit- und Taktschaltblockes 20 weitergeleitet. Im Umlaufbetrieb werden die Daten am Datenausgangsanschluss nicht benutzt, sondern die vom Abfrageverstärker 22 kommenden Bits werden über den Leit- und Taktschaltblock 20 wieder in das serielle Eingaberegister 10 eingegeben. Durch diesen dauernden Umlauf des Datenbitstromes wird ein Informationsverlust in den Ladungskopplungselementen verhindert.

Es besteht im vorliegenden die Absicht darin, Daten auf bekannte Art einer SPS-Struktur umlaufen zu lassen, wie es oben beschrieben wurde. Ein Datensatz muss jedoch eingegeben und ausgegeben werden können wie schraffiert in Fig. 1 dargestellt. Zur besseren Beschreibung wurden die Bitpositionen in Fig. 1 bezeichnet. Die Anordnung enthält N-1 Zeilen im parallelen Mittelteil, von denen die erste Zeile die Z Bits speichert, während die N-1 Zeile die B Bits speichert. $(M+1) \times N$ Bits werden insgesamt gespeichert, da die A Bits im seriellen Ausgaberegister gespeichert werden. Jede Spalte speichert einen gewünschten Datensatz, der aus den Datenbits A bis Z besteht. Die schraffierten Zellen zeigen die serielle Bahn, auf der ein Datensatz eingegeben oder ausgegeben wird.

Insbesondere der Datensatz 2, d.h. A2 B2 ... Z2, ist in Ruheposition gezeigt. Der Datensatz ist analog der zeilenadressierbaren Spalte einer herkömmlichen zeilenadressierbaren Struktur. In diesem Beispiel wurde das Eingaberegister 10 mit Nullbits gefüllt. Nach dem Erfindungsgedanken kann man die schraffierten Bits in folgender Reihenfolge auslesen: A0, A1, A2, B2 bis Z2 und die Nullbits, wie es im schraffierten Teil des Registers dargestellt ist. Während diese Bits am Datenausgangsanschluss ausgelesen werden, laufen sie auch durch den Leit- und Taktschaltblock 20 um, so dass am Ende der Operation genau die Konfiguration wieder hergestellt ist, die in Fig. 1 gezeigt ist. Jetzt kann man entweder einen anderen Datensatz, z.B. A3 bis Z3, adressieren oder die Erneuerung mit einer herkömmlichen SPS-Operation wieder aufnehmen. Während eine gewünschte Zeile adressiert wird, bleiben natürlich alle anderen Bits in den parallelen Kanälen inaktiv, d.h. sie werden nicht weitergeleitet.

In den schraffierten Teilen des Eingabe- und des Ausgaberegisters befinden sich noch $(M+1)$ zusätzliche Bits, die zusammen mit dem nutzbaren Datensatz bewegt werden müssen, von den logischen Schaltungen des Systems jedoch ignoriert werden.

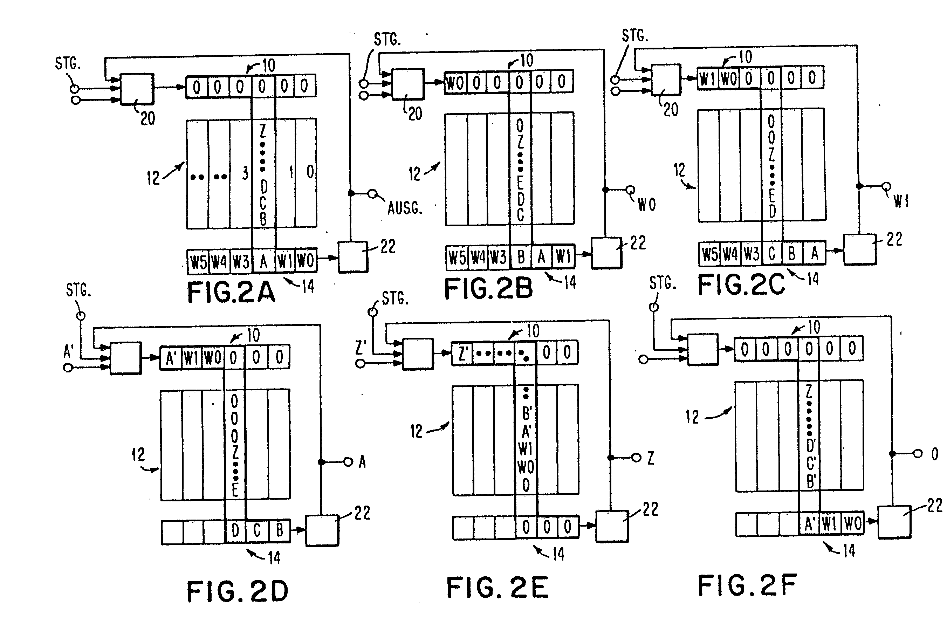

Das in den Fign. 2A bis 2F im einzelnen gezeigte Beispiel verwendet das in Fig. 1 dargestellte Ausführungsbeispiel, in dem die leeren oder Nullbits im Eingaberegister 10 stehen. Der Serien/Parallelwandler 16 und der Parallel/Serienwandler 18 aus Fig. 1 wurden der einfacheren Darstellung halber absichtlich weggelassen. Die Bezeichnung der Bits wurde aus demselben Grund geringfügig geändert.

Unter Bezug auf Fig. 2A wird angenommen, dass der Datensatz Nr. 2, bestehend aus den Bits A, B, C, D bis Z die zu adressierende Zeile ist. Da es der dritte Datensatz ist, zeigt ein Zähler am Ausgangsanschluss im Benutzergerät, dass die Bits W0 und W1 den ersten beiden Datensätzen entsprechen und daher nicht Teil der adressierten Zeile sind. Nach Darstellung in Fig. 2B ist also das Bit W0 das erste ausgehende Bit, das auch in die erste Bitposition im seriellen Eingaberegister 10 geschrieben wird, wenn jedes Bit um eine Position verschoben wird. Fig. 2C zeigt die Situation, wenn jedes Bit um eine weitere Position verschoben wurde, wobei W1 ausgelesen und in die erste Bitposition in das serielle Register 10 gesetzt wird, während alle anderen Bits entsprechend um eine Position verschoben werden. In Fig. 2D ist gezeigt, wie das Auslesen der adressierten Zeile beginnt mit dem Auslesen von Bit A. Um die Situation besser darzustellen, in der dieselben Daten nicht umlaufen gelassen werden, wird ein neues Bit A mit der Bezeichnung A' an den Eingangsanschluss angelegt und in die erste Bitposition des Eingaberegisters 10 gesetzt. Alle Bits werden entsprechend verschoben wie vorher beschrieben.

Dieser Ausschiebeprozess des gewünschten Datensatzes geht weiter, während die neuen Bits eingeschoben werden, bis der in Fig. 2E gezeigte Zustand erreicht ist. Hier wurde das letzte Bit (Z) an den Datenausgangsanschluss gegeben und das neue Bit in die erste Position des Eingaberegisters 10 gesetzt. An diesem Punkt sind die Daten fertig ausgelesen, obwohl noch einige weitere Zyklen erforderlich sind, um die Datenbits in ihre Ausgangsposition zurückzuschieben. Das ist in Fig. 2F gezeigt, wo alle Datenbits wieder in ihrer ursprünglichen Position stehen und die Bits A', B', C', D' bis Z' ihre ursprünglichen Bits ohne die Strichbezeichnung in Fig. 2A ersetzt haben. Auf diese Weise arbeitet ein serieller-paralleler-serieller Speicher im Zeilenadressbetrieb, wo jeder gewünschte Datensatz beliebig adressiert werden kann. Der Vorteil dieser Struktur besteht in der offensichtlichen Reduzierung der Latenzzeit. Wenn der Datensatz Z der Fig. 1 gewünscht wird, muss man im herkömmlichen SPS-Betrieb warten, bis die ganze Gruppe adressiert ist. Durch das gezeigte LA-SPS-Betriebsverfahren beläuft sich die Latenzzeit im ungünstigsten Falle auf die Schiebezeit von M Bits, wenn irgendein Datensatz gewünscht wird. Für den in Fig. 1 gezeigten Fall ist die Latenzzeit nur genauso gross, wie die Schiebezeit für die Bits A0 und A1. Eine weitere Verschiebung muss jedoch vorgenommen werden, um die Daten wieder in ihre ursprüngliche Konfiguration zu setzen und die Operation zu beenden.

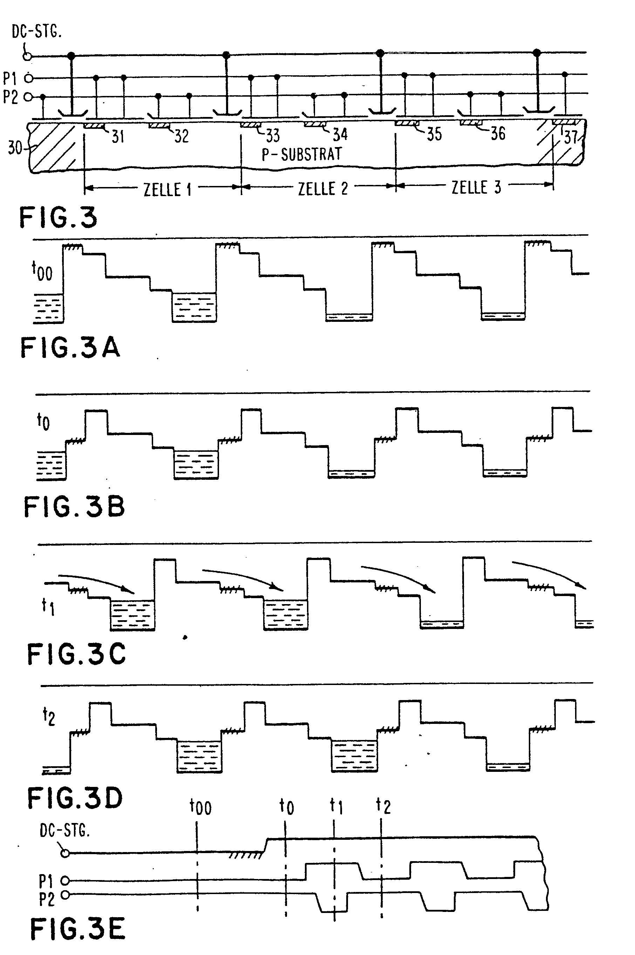

Eine beispielhafte Struktur zur Ausführung dieser Funktion ist in Fig. 3 gezeigt, wo in einem P-leitenden Substrat 30 P+ Bereiche 31, 32, 33, 34, 35, 36 und 37 durch Ionenimplantation geschaffen wurden. Einzelheiten einer jeden Zelle sind an der Zelle 1, 2 und 3 gezeigt. Zu jeder Zelle gehören drei Elektroden, nämlich eine Gleichspannungs-Steuerleitung, eine Phase 1 (P1) und eine Phase 2 (P2). Durch Anlegen drei verschiedener Potentialpegel an die drei verschiedenen Elektroden können bekanntlich in jeder Zelle drei verschiedene Energieniveaus geschaffen werden. Durch die zusätzliche Ionenimplantation unter einem Teil der Gateelektrode können jedoch unter dieser Gateelektrode zwei Energieniveaus geschaffen werden. Durch die Ionenimplantation 31 unter einem Teil der Gateelektrode für die Phase 1 kann man also zwei separate Energieniveaus unter dieser Gateelektrode schaffen. Entsprechendes gilt für Ionenimplantation 32 unter der Gateelektrode der Phase 2. Unter der Gateelektrode für die Gleichspannungs-Steuerleitung liegt keine Ionenimplantation, so dass hier nur ein Energieniveau erzeugt werden kann. Insgesamt bieten die drei Elektroden die Möglichkeit, fünf Energieniveaus in jeder Zelle zu erzeugen. Fig. 3E zeigt die angelegten Potentialpegel, während die Fign. 3A bis 3D die Weiterleitung der Ladung durch die Zellen darstellen.

Die Fign. 3A bis 3E zeigen den Zustand, in dem Ladung durch die Schaltungsanordnung weitergeleitet wird. Dieser Vorgang läuft während der SPS-Operation in jeder Zeile ab. Die Fign. 3A bis 3E zeigen den Zustand der adressierten Zeile im Zeilenadressierbetrieb. Die zur Zeit $t_{00}$ angelegten Potentialpegel sind in Fig. 3E dargestellt. Die Gleichspannungs-Steuerleitung sowie die Leitung für die Phase 1 befinden sich auf einem niedrigen Pegel, die Leitung für die Phase 2 auf einem hohen. Das resultiert in der in Fig. 3A gezeigten Potentialtopfkonfiguration. In dem in Fig. 3A gezeigten Beispiel wird eine binäre 1 in Zelle 1 und in der vorhergehenden Zelle gespeichert, während in den Zellen 2 und 3 Nullen gespeichert werden. Zur Zeit $t_0$ wird die Gleichspannungs-Steuerleitung auf einen hohen Pegel gebracht, während der Signalpegel auf den Leitungen für die Phasen 1 und 2 nicht verändert wird. Dadurch werden die Potentialtöpfe anders angeordnet, und zwar so wie es in Fig. 3B gezeigt ist. Zur Zeit $t_1$ wurde die Elektrode für die Phase 1 auf einen hohen Signalpegel gebracht, während die Elektrode für die Phase 2 auf einen niedrigen Pegel gebracht wurde und die Steuerleitung auf einem hohen Pegel gehalten wurde. Das führt zu der in Fig. 3C gezeigten Anordnung der Potentialtöpfe und einer Ladungsübertragung in der in Fig. 3C durch die Pfeile angezeigten Richtung.

Zur Zeit $t_2$ wird die Gleichspannungs-Steuerleitung auf einem hohen Pegel gehalten, während die Leitung für die Phase 1 auf einem niedrigen und die Leitung für die Phase 1 auf einen hohen Pegel gebracht wurde. Das führt zu der in Fig. 3D gezeigten Verteilung der Potentialtöpfe. Die Ladungsübertragung ist im wesentlichen abgeschlossen, wobei die Zelle 1 eine binäre 1 enthält, die vorher in der vorhergehenden Zelle stand, die Zelle 2 ebenfalls eine binäre 1, die vorher in der Zelle 1 stand und die Zelle 3 die fette Null enthält, die vorher in der Zelle 2 stand.

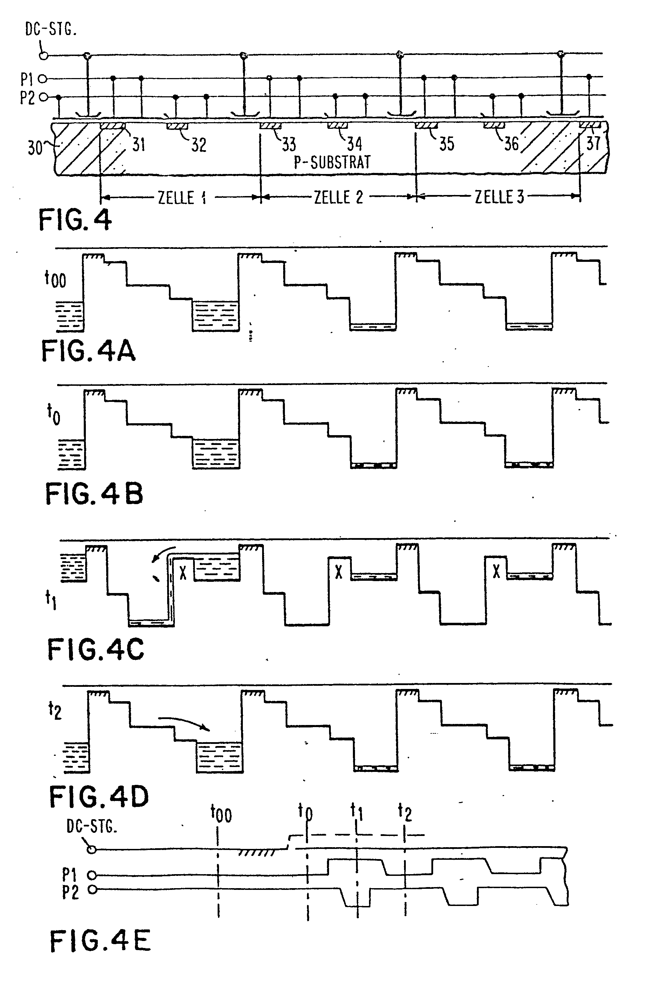

Fig. 4 zeigt die gleiche Struktur wie Fig. 3. Im Zusammenhang mit den Fign. 4 und 4A bis 4E wird der Zustand der inaktiven Leitungen während des Zeilenadressierbetriebes gezeigt. Die Anfangszustände der Steuerleitungen in Fig. 4E sind mit denen der Fig. 3E zur Zeit $t_{00}$ identisch. Ausserdem werden identische binäre Daten gemäss Darstellung in Fig. 4A gespeichert, wie in Fig. 3A. Somit ist Fig. 4A also mit Fig. 3A identisch. Zur Zeit $t_0$ hat sich gegenüber dem Zustand zur Zeit $t_{00}$ nichts geändert, und daher sind auch die Potentialtöpfe in Fig. 4B mit denen in Fig. 4A absolut identisch.

Zur Zeit $t_1$ ist in Fig. 4E im Gegensatz zur Fig. 3E festzustellen, dass die Gleichspannungs-Steuerleitung auf einem niedrigen Signalpegel gehalten wird, während die Leitung der Phase 1 auf einen hohen und die der Phase 2 auf einen niedrigen Signalpegel gebracht wurden. Das führt zu der in Fig. 4C gezeigten Verteilung der Potentialtöpfe. Der Potentialtopf, der eine Ladung enthält, die Information darstellt, wird auf einen höheren Signalpegel angehoben, und der Teil der binären 1-Ladung, der die Tiefe des Topfes X überschreitet, «schwappt zurück» in den vorhergehenden Potentialtopf. Zur nachfolgenden Zeit $t_2$ wird die Leitung für die Phase 1 auf einen niedrigen Signalpegel gebracht, während die Leitung der Phase 2 auf einen hohen Signalpegel gebracht und so die Potentialtopfanordnung erzeugt wird, die in Fig. 4D gezeigt ist, die mit der Fig. 4B identisch ist. Dadurch kann sich die Anordnung der Potentialtöpfe zwischen den Anordnungen der Fign. 4C und 4D vorwärts und rückwärts verändern und auf diese Weise die Information in allen nicht gewählten Leitungen «stationär» gehalten werden. Dieser Zustand herrscht auf allen Zeilen vor, auf denen die Gleichspannungs-Steuerleitung auf einem niedrigen Potential gehalten wird. Die Gleichspannungs-Steuerleitung übernimmt also eine Sperrfunktion und kann bei derartiger Verwendung auch als Sperrleitung bezeichnet werden. Die Adresswahlschaltung gestattet ein Hochschalten des Signalpegels auf der Sperrleitung nur in der gewählten Zeile, während er auf allen anderen Zeilen niedrig gehalten wird.

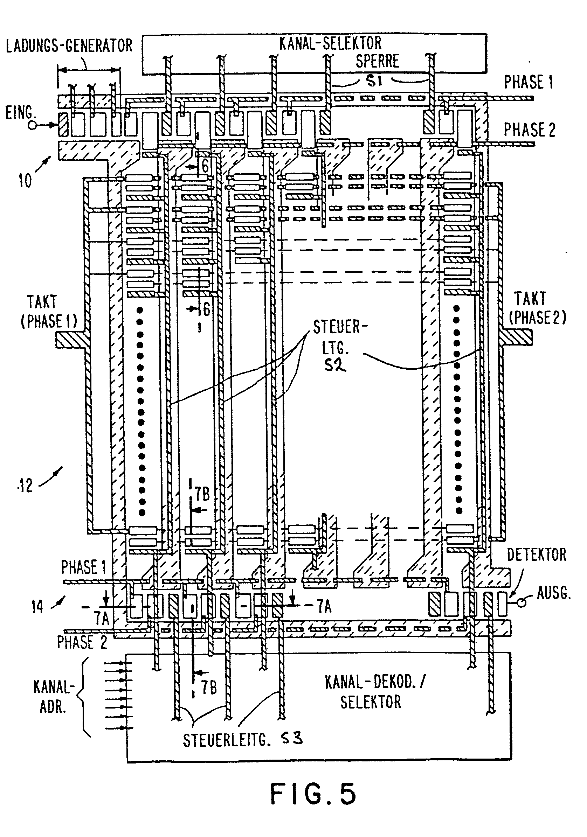

Im Zusammenhang mit Fig. 5 wird eine Schaltung beschrieben, die für die Ausführung des SPS-Betriebes sowie des Zeilenadressierbetriebes geeignet ist. Allgemein bekannte Operationen wie Übertragungen innerhalb eines seriellen Registers, Übertragungen innerhalb eines parallelen Registers und Serien/Parallelumsetzungen oder Parallel/Serienumsetzungen sowie andere Einzelheiten der Ladungserzeugung und -abführungen werden nicht im einzelnen beschrieben, da sie allgemein bekannt sind.

Ein Gesichtspunkt der in Fig. 5 gezeigten Konfiguration ist die Verwendung von mittels Gleichstrom gesteuerten Ladungskopplungselementen für die zeilenadressierbare SPS-Speicheranordnung. Solche Ladungskopplungselemente brauchen eine Gleichstrom-Steuerleitung für jeden parallelen Kanal, können aber mit gemeinsamen Taktleitungen für alle parallelen Kanäle betrieben werden. Das ist insofern ein wichtiger Punkt, als hierdurch eine sehr dichte Schaltungsanordnung ermöglicht wird. Das bedeutet, dass sämtliche Schaltungs- und Raumeinsparungen direkt dem Konzept der zeilenadressierbaren seriellen-parallelen-seriellen Speicheranordnung zuzuschreiben sind.

Fig. 5 zeigt primär den Lauf der Takt- und Steuerleitungen. Das serielle Eingaberegister 10, der parallele Mittelteil 12 und das serielle Ausgaberegister 14 sind wieder genauso numeriert wie in den vorhergehenden Zeichnungen. Das serielle Eingaberegister 10 empfängt eine Eingabe in einem Erzeugungsteil und es empfängt die Verbindung der Elektroden für die Phasen 1 und die Phase 2. Zusätzlich zum herkömmlichen zweiphasigen seriellen Eingaberegister sind hier die Sperrleitungen (S1) vom Kanalwähler vorhanden. Hierbei handelt es sich um die oben beschriebenen Gleichstrom-Steuerleitungen, die während der Zeilenadressierung selektiv aktiviert werden müssen. Datenbits werden im SPS-Betrieb in allen seriellen Eingaberegistern und im Zeilenadressierbetrieb selektiv übertragen, abhängig von der adressierten Zeile, wie es beispielsweise im Zusammenhang mit Fig. 1 beschrieben wurde. Die beiden Zellengruppen des seriellen Eingaberegisters 10 sind genauso angeordnet, wie es oben im Zusammenhang mit den Fign. 3 und 4 beschrieben wurde.

Im parallelen Teil sind die eine gewählte und alle anderen Zellenspaltungen genauso angeordnet, wie es oben im Zusammenhang mit den Fign. 3 und 4 beschrieben wurde. Die Verbindung der parallelen Kanaltaktleitungen für die Phase 1 und 2 ist besonders gezeigt. Die zeitliche Beziehung der Phase 1 zur Phase 2 im seriellen und parallelen Teil wird wunschgemäss und abhängig von der jeweiligen Art gewählt, in der die Serien/Parallelumwandlung erfolgen soll (siehe Fign. 3E und 4E). Insbesondere sind die parallelen Kanalsteuerleitungen (S2) zu beachten, die an jeder Spalte entlanglaufen. Sie entsprechen den Gleichspannungs-Steuerleitungen, die im Zusammenhang mit den Fign. 3 und 4 beschrieben wurden. Durch Anordnung einer derartigen Leitung in jeder Spalte im parallelen Teil kann man im Zeilenadressierbetrieb jede gewählte Spalte aktivieren, während alle anderen gesperrt werden. Diese parallelen Kanalsteuerleitungen werden durch den Kanaldecodierer/wähler gesteuert, der eine Kanaladresse empfängt. Der Kanaldecodierer/wähler steuert auch die seriellen Kanalsteuerleitungen (S3) im seriellen Ausgaberegister 14. Nachdem also die Bits von der letzten Zeile des parallelen Mittelteiles 12 (entweder parallel im SPS-Betrieb oder bitweise wie im Zeilenadressbetrieb) übertragen sind, werden sie seriell aus dem seriellen Ausgaberegister 14 durch die Taktimpulse der Phase 1 und der Phase 2 über den Detektor an den Ausgabeanschluss ausgeschoben.

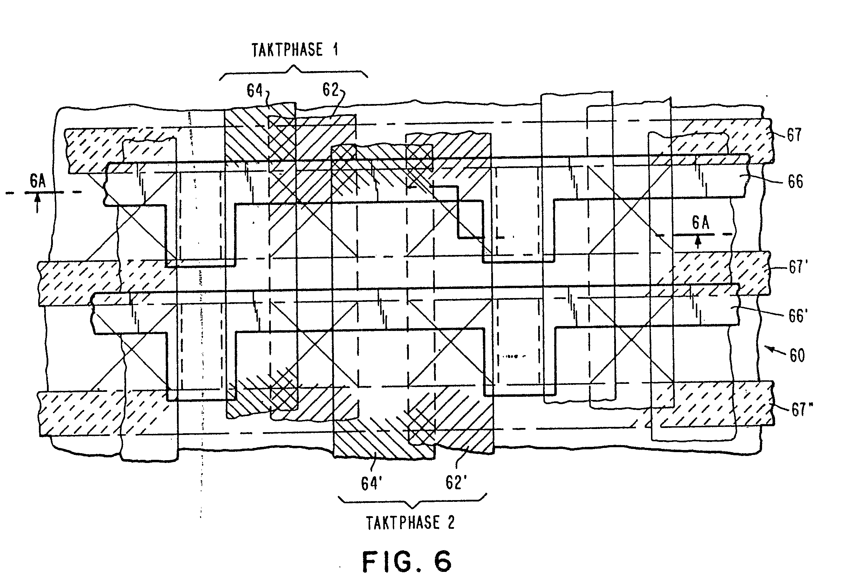

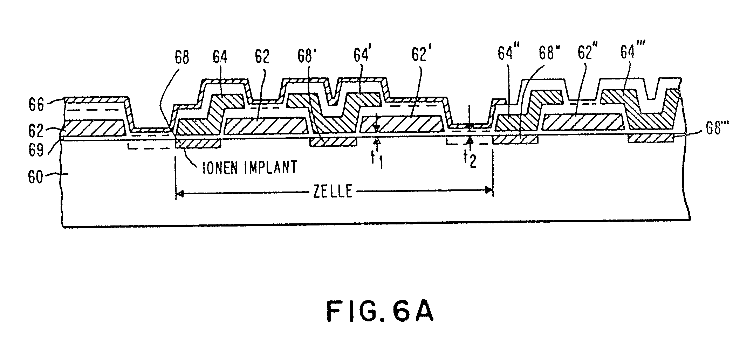

Fig. 6 ist eine vergrösserte Darstellung der in Fig. 5 gezeigten Struktur im Bereich der Schnittlinie 6. In Fig. 6 sind Teile von zwei parallelen Spalten dargestellt. Das Substrat 60 ist typischerweise mit P-leitenden Verunreinigungen dotiert. Die Herstellung von Ladungskopplungselementen mit N-leitenden Substraten ist natürlich auch bekannt. Ionenimplantationen sowie die verschiedenen Elektroden aus Polysilizium und Metall werden in der gezeigten Anordnung mit bekannter Lithographietechnik hergestellt. Die Taktleitungen für die Phase 1 werden mit den Polysiliziumelektroden 62 und 64 gebildet, wobei die Elektrode 62 mit Poly 1 und die Elektrode 64 mit Poly 2 bezeichnet wird. Diese Bezeichnung wurde festgelegt in der Reihenfolge, in der die verschiedenen Polysiliziumelektroden mit den verschiedenen dazwischen liegenden Isolierschichten aus Siliziumdioxid ausgebildet werden. Die Taktleitungen der Phase 2 werden durch die Polysiliziumelektroden 62' und 64' gebildet. Der oberste Schichtleiter (im allgemeinen aus Metall gebildet) ist die Sperrleitung 66 für eine Spalte und die Sperrleitung 66' für die andere Spalte. Die erste Spalte ist von der zweiten Spalte durch eine vertiefte Oxidisolation 67' getrennt. Die erste Spalte ist von der anderen benachbarten Spalte durch die Oxidvertiefung 67 getrennt, während die zweite gezeigte Spalte von der nächsten Nachbarspalte durch das vertiefte Oxid 67" getrennt ist. Die Oxidisolation sowie andere Isolationsarten zwischen den Spalten sind zwar allgemein bekannt, für die vorliegende Erfindung jedoch besonders nützlich, als die Gesamtstruktur in allen möglichen Hinsichten zwar der bekannten SPS-Anordnung entspricht, sich jedoch von ihr durch die zusätzliche hier beschriebene Zeilenadressiereinrichtung unterscheidet.

Fig. 6A zeigt einen vertikalen Schnitt durch die Struktur der Fig. 6 entlang der Schnittlinie 6A. Fig. 6A ist eine detaillierte Darstellung des im Zusammenhang mit den Fign. 3 und 4 beschriebenen Schemas. Auf dem Substrat 60 werden die verschiedenen Elektroden 62, 64 und 66 sowie die Ionenimplantationen 68, 68' usw. ausgebildet. Bei einem P-leitenden Substrat sind die Ionenimplantationen P+-leitend. Die Sperrelektrode ist im allgemeinen ein Metall, dreifache Polystrukturen sind jedoch ebenso bekannt. Die Elektrode 66 kann genausogut aus Polysilizium hergestellt sein. Die verschiedenen Elektroden sowie das Substrat sind in geeigneter Weise voneinander durch Siliziumdioxid isoliert.

Eine typische Zelle, entsprechend z.B. der Zelle 1 in den Fign. 3 und 4, ist in Fig. 6A gezeigt. Die Elektrode für die Phase 1 (P1) enthält Poly 1 (62) und Poly 2 (64) und zeigt deutlich die in den Fign. 3 und 4 nur schematisch dargestellte Verbindung der beiden Elektroden. Unter der Poly 2 Elektrode 64 wurde die Ionenimplantation 68 ausgebildet.

Der Anschluss für die Phase 2 (PZ) ist an die Elektrode 62' (Poly 1) und 64' (Poly 2) angeschlossen, wobei letztere über der Ionenimplantation 68'

ausgebildet ist. Der letzte Anschluss für diese Zelle ist die Gleichstrom-Steuerelektrode 66 (Sperrelektrode). Die dünne Oxidschicht 69 braucht nicht gleichmässig zu sein, so kann beispielsweise die erste Dicke $t_1$ unter den Polysiliziumelektroden 62 und 64 in der Grössenordnung von $5 \times 10^{-8}$ m (500 Å) liegen. Eine zweite Dicke $t_2$ unter den metallischen Steuerelektroden (Speielektroden) kann in der Grössenordnung von $10^{-7}$ m (1000 Å) liegen.

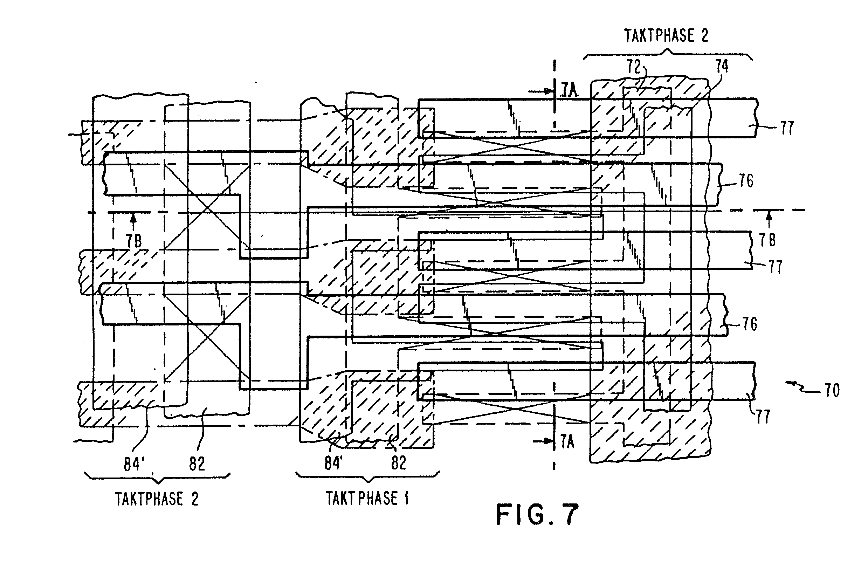

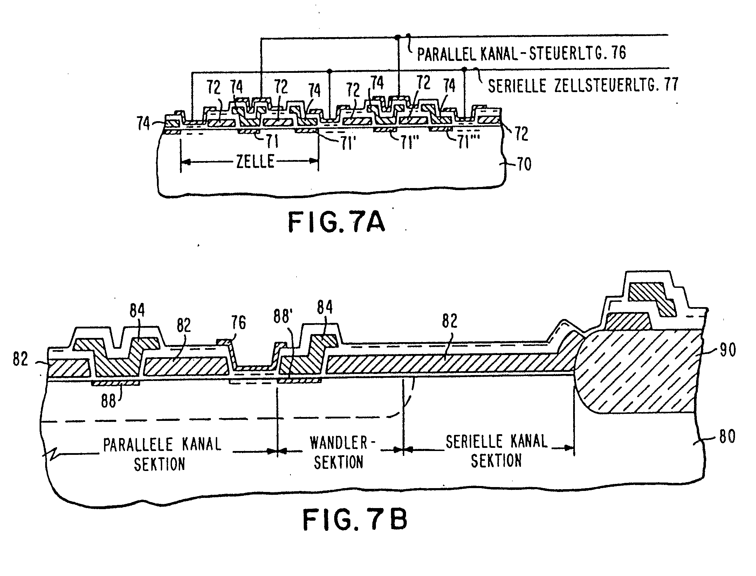

Fig. 7 ist eine Vergrösserung der Darstellung in Fig. 5 im Bereich der Schnittlinien 7A und 7B. Das Substrat wurde mit der Bezugszahl 70 bezeichnet. Der in Fig. 7 vergrössert dargestellte Bereich enthält einen Teil des parallelen Kanales, einen Teil des Parallel/Serienwandlers und einen Teil des seriellen Kanales. Entlang der Schnittlinie 7B ist in Fig. 7 ein Teil des parallelen Kanales, ein Teil des Parallel/Serienwandlers und ein Teil des seriellen Kanales gezeigt. In Fig. 7 ist ausserdem entlang der Schnittlinie 7A nur ein Teil des seriellen Kanales gezeigt.

In dem Teil des in Fig. 7, 7A und 7B gezeigten parallelen Kanales werden die Taktleitungen für die Phase 2 gebildet durch die Elektroden 82 und 84, wobei die Elektrode 82 Poly 1 ist und die Elektrode 84 Poly 2. Im Übergangs- oder Wandlerbereich werden die Elektroden 82' und 84' für die Taktphase 1 gebildet durch Poly 1 bzw. Poly 2. Im seriellen Kanal werden die Elektroden 72 und 74 für die Taktphase 2 gebildet durch Poly 1 bzw. Poly 2. Die parallelen Kanalsteuerleitungen 76 (Sperrleitungen) laufen vom parallelen Kanal über den seriellen Kanal, beeinflussen diesen jedoch nicht, weil sie vom Substrat durch eine dicke Oxidschicht getrennt sind. Die seriellen Steuerelektroden 77 jedoch liegen nur im seriellen Kanalbereich und haben dieselbe Sperr- oder Übertragungsfunktion, die oben für die parallelen Kanalsteuerleitungen beschrieben wurden.

Fig. 7A zeigt einen vertikalen Schnitt durch die in Fig. 7 gezeigte Struktur entlang der Schnittlinie 7A. Es ist ein Teil des seriellen Ausgaberegisters dargestellt (das serielle Eingaberegister hat natürlich genauso aufgebaute Zellen). Im P-leitenden Substrat sind mehrere P+-leitende Ionenimplantationen 71, 71', 71", 71''' ausgebildet. Durch Siliziumdioxid in geeigneter Weise voneinander isoliert liegen die Poly 1 Elektrode 72 und die Poly 2 Elektrode 74. Die parallelen Kanalsteuerleitungen 76 sind vom Substrat nicht durch ein dickes Oxid, sondern auch durch die entsprechenden Polysiliziumelektroden getrennt, und haben daher keinen Einfluss auf die Weiterleitung der Ladung. Die seriellen Leiter 77 jedoch sind vom Substrat nur durch ein dünnes Oxid getrennt. Das die Metallsteuerelektroden vom Substrat trennende dicke Oxid kann etwa $10^{-7}$ m (1000 Å) dick sein, das die Polyelektroden vom Substrat trennende dünne Oxid etwa $5 \times 10^{-8}$ m (500 Å). Die in Fig. 7A gezeigte typische Zelle hat als Steuerelektrode die seriellen Steuerelektroden 77. Die Leitung für die Taktphase 2 ist sowohl an die Poly 1 Elektrode 72 als auch an die Poly 2 Elektrode 74 angeschlossen, die im wesentlichen über der Ionenimplantation 71 liegt. Die Steuerleitung für die Phase 1 ist an die Poly 1 Elektrode 72 und die Poly 2 Elektrode 74 angeschlossen, die im wesentlichen über die Ionenimplantation 71' liegt. In dieser Schaltungsanordnung wird die Ladung von rechts nach links weitergeleitet.

Fig. 7B zeigt einen Schnitt durch die in Fig. 7 gezeigte Struktur entlang der Schnittlinie 7B. Im parallelen Kanalteil werden die Elektroden für die Taktphase 2 durch die Poly 1 Elektrode 82 und die Poly 2 Elektrode 84 gebildet, die im wesentlichen über der Ionenimplantation 88 liegt.

Die Elektroden für die Taktphase 1 werden durch die teilweise gezeigte Poly 1 Elektrode 82 mit einer anderen Poly 2 Elektrode gebildet (nicht dargestellt). Die Steuerelektrode 76 bildet den Sperrkontakt für die gezeigte Zelle im parallelen Kanalteil. Im Wandlerteil werden die Elektroden für die Taktphase 1 durch die Poly 1 Elektrode 82' und die Poly 2 Elektrode 84' gebildet, die im wesentlichen über der Ionenimplantation 88' liegt. Der serielle Kanalteil ist besser in Fig. 7A dargestellt. Rechts vom seriellen Kanalteil ist in Fig. 7B eine typische vertiefte Oxidisolation 90 dargestellt. Das Substrat wurde in Fig. 7B mit der Nummer 80 bezeichnet.

Vorstehend wurde eine zweiphasige Ausführung der Erfindung beschrieben. Gemeinsame Taktleitungen werden für jede Speicherspalte benutzt, wie es bei SPS-Schaltungsanordnungen üblich ist. Damit wird die hohe Dichte der SPS-Schaltungen erhalten. Für die erhöhte Flexibilität der Zeilenadressierung ist lediglich eine Gleichspannungs-Steuerleitung für jeden Kanal erforderlich. Die Verwendung eines Leiters auf einer dritten Ebene für die Gleichstrom-Steuerelektroden (Sperrelektroden) ist keine wesentliche Belastung für eine vorhandene SPS-Schaltung. Da eine Metallebene gewöhnlich als integrierter Teil bei der Herstellung eines Ladungskopplungselementes mit zwei selbst ausrichtenden Polysiliziumelektroden ist, ist die Verwendung von Metall für die Gleichstrom-Steuerelektroden sehr bequem. Die Verwendung von Metallelektroden auf dünnem Oxid ist jedoch zuverlässiger, wenn das dünne Oxid unter dem Metall dicker ist als unter dem Polysilizium, weil die Gleichspannungs-Steuerelektroden das Energieniveau unter sich nur ungefähr halb so viel zu ändern brauchen, wie die Elektroden unter dem Polysilizium. Durch eine dickere Oxidschicht unter den Metallelektroden verursacht die gleiche angelegte Gleichspannung unter diesen Metallelektroden eine geringere Energieänderung. Andererseits könne kleinere Gleichspannung an die Metallelektroden angelegt werden, so dass überall das dünne Oxid eine gleichmässige Dicke haben kann. Die relativen Spannungspegel für die Taktphasen 1 und 2 und die Gleichspannungs-Steuerelektroden sind an sich bekannt, mit denen die gezeigten Potentialbarrieren unter den verschiedenen Steuerelektroden errichtet werden. Der niedrige Pegel für die beiden Taktsignale Phase 1 und Phase 2 muss beispielsweise eine ausreichend hohe Spannung haben, so dass die Richtungsbarriere unter den Ionenimplantationen nicht diejenige unter den Gleichspannungs-Steuerelektroden überschreitet. Der Richtungssinn kann in zweiphasigen Ladungskopplungselementen bekanntlich auch mit anderen Techniken als der Ionenimplantation erreicht werden, beispielsweise durch eine Versetzung von dünnem und dickem Oxid.

Bisher wurde die Modifikation einer SPS-Schaltungsanordnung zu einer zeilenadressierbaren SPS-Schaltungsanordnung beschrieben. Es kann aber auch eine zeilenadressierbare Schaltungsanordnung so modifiziert werden, dass sie eine SPS-Funktion enthält.

**Patentansprüche**

1. Zeilenadressierbarer Speicher in Serien-Parallel-Serien-Konfiguration aus seriell-parallel-seriell geschalteten Schieberegistern, deren Speicherzellen aus Ladungskopplungselementen bestehen, der aus drei Hauptteilen besteht, wovon der erste Teil (10, Fig. 5) zur bitweisen Dateneingabe in ein serielles Eingaberegister dient, der zweite Teil (12) zur parallelen Übertragung vom Eingaberegister in parallele Kanäle und der dritte Teil (4) zur Übertragung der Daten aus der letzten Zeile des zweiten Teils in ein serielles Ausgaberegister, dadurch gekennzeichnet, dass mit dem Eingaberegister (10) zwei Phasensteuerleitungen (P1 und P2) verbunden sind, dass ausserdem Sperrleitungen (51) mit dem Eingaberegister verbunden sind, deren Anzahl gleich der Anzahl der parallelen Kanäle ist und die als Gleichstromsteuerleitungen ausgeführt sind und während der Zeilenadressierung selektiv aktiviert werden, dass die zwei Phasensteuerleitungen (P1 und P2) allen parallelen Kanälen gemeinsam zugeordnet sind, dass die Ladungskopplungselemente für jeden parallelen Kanal eine Gleichstrom-Steuerleitung (S2) aufweisen, die an dem jeweiligen parallelen Kanal entlang verläuft und mit einem Kanalselektor verbunden ist, wodurch im parallelen Teil jeder gewählte Kanal im Zeilenadressierbetrieb aktiviert werden kann, während alle anderen gesperrt werden, und dass das Ausgaberegister (14) ebenfalls mit den zwei Phasensteuerleitungen (P1 und P2) verbunden ist und durch den Kanalselektor mittels Gleichstromsperrleitungen (S3) gesteuert wird, wobei im Zeilenadressierbetrieb ein Datenumlauf über einen selektierbaren Eingaberegisterteil, einen selektierbaren parallelen Kanal und über einen selektierbaren Ausgaberegisterteil erfolgt.

2. Zeilenadressierbarer Speicher nach Anspruch 1, dadurch gekennzeichnet, dass die nacheinander angeordneten Zellen innerhalb eines Registers durch P+-Bereiche (31 und 37) in einem P-leitenden Substrat (30) gebildet werden, dass jede Zelle (1 bis 3) drei Elektroden aufweist, nämlich eine für die Gleichspannungs-Steuerleitung und zwei für die Phasensteuerung (P1 und P2).

3. Zeilenadressierbarer Speicher nach Anspruch 2, dadurch gekennzeichnet, dass durch Anliegen drei verschiedener Potentialpegel an die drei verschiedenen Steuerleitungen in jeder Zelle (1 bis 3) drei verschiedene Energieniveaus erzeugt werden, dass durch eine zusätzliche Ionenimplanta-

tion (31) unter einem Teil einer Gateelektrode für die Steuerphase (P1) zwei separate Energieniveaus unter dieser Gateelektrode erzeugt werden und dass unter der Gateelektrode für die Gleichspannungs-Steuerleitung kein Bereich durch Ionenimplantation gebildet ist, wodurch hier nur ein Energieniveau erzeugt wird.

4. Zeilenadressierbarer Speicher nach einem der Ansprüche 1 bis 3, dadurch gekennzeichnet, dass durch die drei mit den Steuerleitungen (P1, P2 und DC) verbundenen Gateelektrode fünf Energieniveaus in jeder Zelle (1, 2 oder 3) erzeugen.

5. Zeilenadressierbarer Speicher nach einem der Ansprüche 1 bis 4, dadurch gekennzeichnet, dass auf einem Substrat (60) die verschiedenen Elektroden (62, 64 und 66) und Ionenimplantationen (68, 68' usw.) ausgebildet sind, dass bei einem P-leitenden Substrat die Ionenimplantationen vom P+ Typ sind und die Sperrelektrode aus Metall oder einer dreifachen Polystruktur gebildet ist, wobei die verschiedenen Elektroden sowie das Substrat durch Siliziumdioxid voneinander isoliert sind.

6. Zeilenadressierbarer Speicher nach Anspruch 5, dadurch gekennzeichnet, dass die Elektrode für die Phase 1 (P1) Poly 1 (62, Fig. 6A) und Poly 2 (64) enthält, dass unter der Poly 2 enthaltenden Elektrode (64) eine Ionenimplantation (68) ausgebildet ist, dass der Anschluss für die Phase 2 (P2) an die folgenden beiden Elektroden (62' und 64') angeschlossen ist, wobei die letztere der beiden durch eine Ionenimplantation (68') ausgebildet ist, dass der letzte Anschluss für diese Zelle die Gleichstrom-Steuerelektrode (66), die als Sperrelektrode wirkt ist und dass die Oxidschicht (69) zwei verschiedene Dicken (T1 und T2) aufweist.

**Claims**

1. Line-addressable storage in serial-parallel-serial configuration of serial-parallel-serial arranged shift registers whose storage cells consist of charge coupling elements, said storage consisting of three main parts, the first part (10, Fig. 5) serving for the bit-wise data input into a serial input register, the second part (12) for the parallel transfer from the input register into parallel channels, and the third part (14) for the transfer of data from the last line of the second part into a serial output register, characterized in that connected to the input register (10) two phase control lines (P1 and P2) are provided, that furthermore the input register has connected thereto inhibit lines (SI) whose number equals the number of parallel channels, and which are designed as DC control lines and which are selectively activated during line addressing, that the two phase control lines (P1 and P2) are jointly associated to all parallel channels, that the charge coupling elements provide for each parallel channel a DC control line (S2) which extends along the respective parallel channel and is connected to a channel selector, so that in the parallel part each selected channel can be activated in line addressing operation while all others are rendered non-conductive, and that the output register (14) is also connected to the two phase control lines (P1 and P2) and is controlled by the channel selector by means of DC inhibit lines (S3), a data circulation via a selectable input register part, a selectable parallel channel, and a selectabel output register part being effected in line addressing operation.

2. Line-addressable storage as claimed in claim 1, characterized in that the successively arranged cells within one register are formed by P+ regions (31 to 37) in a P-conductive substrate (30), that each cell comprises 1 to 3 electrodes, i.e. one for the DC control line and two for the phase control (P1 and P2).

3. Line-addressabel storage as claimed in claim 2, characterized in that through the application of three different potential levels to the three different control lines in each line (1 to 3) three different power levels are generated, that by additional ion implantation (31) among part of a gate electrode for the control phase (P1) two separate power levels are produced under this gate electrode, and that under the gate electrode for the DC control line no region is formed by ion implantation so that only one power level is produced here.

4. Line-addressable storage as claimed in any one of claims 1 to 3, characterized in that through the three gate electrodes connected to the control lines (P1, P2, DC) five power levels in each cell (1, 2 or 3) are generated.

5. Line-addressable storage as claimed in any one of claims 1 to 4, characterized in that on a substrate (60) the various electrodes (62, 64 and 66) and ion implantations (68, 68' etc.) are provided, that with a P-conductive substrate the ion implantations are of the P+ type, and the barrier electrode of metal or a triple polystructure, the various electrodes as well as the substrate being insulated from each other by means of silicon dioxide.

6. Line-addressable storage as claimed in claim 5, characterized in that the electrode for phase 1 (P1) contains Poly 1 (62, Fig. 6A) and Poly 2 (64), that under the electrode (64) containing Poly 2 there is an ion implantation (68), that the connection for phase 2 (P2) is connected to the following two electrodes (62' and 64'), the latter of the two being provided by an ion implantation (68'), that the last connection for this cell is the DC control electrode (66) acting as a barrier electrode, and that the oxide layer (69) has two different thicknesses (T1 and T2).

**Revendications**

1. Mémoire adressée par ligne dans une configuration série-parallèle-série composée de registres à décalage montés en série-parallèle-série, dont les cellules de mémoire sont composées d'éléments à charges couplées, qui comporte trois parties principales, la première partie (10, figure 5) servant à entrer des données, bit par bit, dans un registre d'entrée série, la seconde partie (12) servant à la transmission parallèle du registre d'entrée aux canaux parallèles, et la troisième partie (14) servant à la transmission des données de la dernière ligne de la seconde partie dans un registre de sortie série, caractérisée en ce que deux lignes de commande de phase (P1 et P2) sont connectées au registre d'entrée (10), en ce que ledit registre d'entrée est en outre connecté à des lignes d'inhibition (S1) dont le nombre est égal au nombre des canaux parallèles et qui sont conçues comme des lignes de commande à courant continu et activées sélectivement lors de l'adressage de lignes, en ce que les deux lignes de commande de phase (P1 et P2) sont associées en commun à tous les canaux parallèles, en ce que les éléments à charges couplées comportent pour chaque canal parallèle, une ligne de commande à courant continu (S2), s'étendant le long de leur canal parallèle respectif qui est connectée à un sélecteur de canal, de telle sorte que dans la partie parallèle chaque canal sélectionné peut être activé en mode d'adressage de lignes alors que tous les autres canaux sont bloqués, et en ce que le registre de sortie (14) est également connecté aux deux lignes de commande de phase (P1 et P2) et qu'il est commandé par le sélecteur de canal à l'aide de lignes d'inhibition à courant continu (S3), les données circulant en mode d'adressage de lignes à travers une partie du registre d'entrée, un canal parallèle et une partie du registre de sortie pouvant tous être sélectionnés.

2. Mémoire adressée par ligne selon la revendication 1, caractérisée en ce que les cellules, disposées en ordre successif, dans un registre sont formées par des régions P+ (31 à 37) dans un substrat de conductivité P (30), et en ce que chaque cellule (1 à 3) comporte trois électrodes, c'est-à-dire une pour la ligne de commande à courant continu et deux pour la commande de phase (P1 et P2).

3. Mémoire adressée par ligne selon la revendication 2, caractérisée en ce que l'on obtient trois différents niveaux d'énergie dans chaque cellule (1 à 3) par application de trois différents niveaux de potentiel aux différentes lignes de commande, en ce qu'on obtient par implantation ionique supplémentaire (31) sous une partie d'une électrode de porte, pour la commande de phase (P1), deux niveaux d'énergie séparés sous cette électrode de porte, et en ce que, sous l'électrode de porte pour la ligne de commande à courant continu, on ne forme pas de région par implantation ionique, en produisant ainsi un seul niveau d'énergie.

4. Mémoire adressée par ligne selon l'une des revendications 1 à 3, caractérisée en ce que les trois électrodes de porte connectées aux lignes de commande (P1, P2, et D, C) produisent cinq niveaux d'énergie dans chaque cellule (1, 2 ou 3).

5. Mémoire adressée par ligne selon l'une des revendications 1 à 4, caractérisée en ce que les différentes électrodes (62, 64 et 66) et implantation ioniques (68, 68', etc.) sont formées sur un substrat (60), en ce que, dans un substrat de conductivité P, les implantations ioniques sont du type P+ et l'électrode de blocage est en métal ou constituée d'une structure de polysilicium triple, les différentes électrodes ainsi que le substrat étant isolés les uns des autres par du dioxyde de silicium.

6. Mémoire adressée par ligne selon la revendication 5, caractérisée en ce que l'électrode pour la phase 1 (P1) est composée de polysilicium 1 (62, figure 6A) et de polysilicium 2 (64), en ce qu'une implantation ionique (68) est pratiquée sous l'électrode (64) en polysilicium 2, en ce que la borne pour la commande de phase 2 (P2) est connectée aux deux électrodes suivantes (62' et 64'), la dernière des deux électrodes étant formée par une implantation ionique (68'), en ce que la dernière borne pour cette cellule est l'électrode de porte à courant continu (66) servant d'électrode de blocage, et en ce que la couche d'oxyde (69) comporte deux couches différentes (T1 et T2).

FIG.1

STG.

10

0 0 0 0 0 0

12

Z ••••• D C B

3 1 0

20

AUSG.

W5 W4 W3 A W1 W0

22

14

**FIG.2A**

STG.

10

W0 0 0 0 0 0

12

O Z ••••• E D C

20

W0

W5 W4 W3 B A W1

22

14

**FIG.2B**

STG.

10

W1 W0 0 0 0 0

12

0 O Z ••••• E D

20

W1

W5 W4 W3 C B A

22

14

**FIG.2C**

STG.

A'

10

A' W1 W0 0 0 0

12

0 0 Z ••••• E

A

D C B

22

14

**FIG.2D**

STG.

Z'

10

Z' ••••• • 0 0

12

•• B' A' W1 W0

Z

0 0 0

22

14

**FIG. 2E**

STG.

10

0 0 0 0 0 0

12

Z ••••• D' C' B'

0

A' W1 W0

22

14

**FIG.2F**

DC-STG.

P1

P2

30

31  32  33  34  35  36  37

P-SUBSTRAT

ZELLE 1    ZELLE 2    ZELLE 3

# FIG.3

$t_{00}$

# FIG.3A

$t_0$

# FIG.3B

$t_1$

# FIG.3C

$t_2$

# FIG.3D

$t_{00}$    $t_0$    $t_1$    $t_2$

DC-STG.

P1
P2

# FIG.3E

DC-STG. ○

P1 ○
P2 ○

30  31  32  33  34  35  36  37

P-SUBSTRAT

|← ZELLE 1 →|← ZELLE 2 →|← ZELLE 3 →|

# FIG. 4

$t_{00}$

# FIG. 4A

$t_0$

# FIG. 4B

$t_1$

X    X    X

# FIG. 4C

$t_2$

# FIG. 4D

$t_{00}$   $t_0$   $t_1$   $t_2$

DC-STG. ○

P1 ○
P2 ○

# FIG. 4E

17

FIG.5

TAKTPHASE 1  TAKTPHASE 2

FIG. 6

67  66  67'  66'  60  67"  64  62  62'  64'  6A

66
62
69
60

68  64  62  68'  64'  62'  64"  68"  62"  64'''

IONEN IMPLANT

$t_1$  $t_2$

68''''

ZELLE

# FIG. 6A

FIG. 7

FIG.7A

FIG.7B